# EUROPEAN PATENT APPLICATION

(11) **EP 4 421 220 A1**
(43) Date of publication of application: **28.08.2024**
(21) Application number: 22883188.9
(22) Date of filing: 08.08.2022
(51) Int. Cl.: C30B 29/36, C23C 16/02, C23C 16/42, C30B 25/18, H01L 21/304

(54) **METHOD FOR PRODUCING POLYCRYSTALLINE SILICON CARBIDE SUBSTRATE**

(30) Priority: 20.10.2021 JP 2021171430
(71) Applicant: Sicoxs Corporation, Minato-ku Tokyo 1050004 (JP)
(72) Inventor: YAGI, Kuniaki, Tokyo 105-0004 (JP)
(74) Representative: TBK
(86) International application number: PCT/JP2022/030247
(87) International publication number: WO 2023/067876

(57) **Abstract**

The present invention provides a method for producing a polycrystalline silicon carbide substrate 33 capable of reducing production costs without changing the quality of the polycrystalline silicon carbide substrate.

The method includes: a carbon layer forming step of forming a carbon layer 21 on a surface of a first underlying substrate 11 to produce a second underlying substrate 12; a polycrystalline silicon carbide film forming step of forming a polycrystalline silicon carbide film 31 on a surface of the second underlying substrate by a chemical vapor deposition method; a carbon layer exposing step of removing an outer peripheral edge of the polycrystalline silicon carbide film formed on the surface of the second underlying substrate to expose the carbon layer; and a polycrystalline silicon carbide film separating step of burning the exposed carbon layer in an oxygen-containing atmosphere and separating the polycrystalline silicon carbide film from the second underlying substrate from which the carbon layer has been removed. By reusing the first underlying substrate without losing it, the production cost of the polycrystalline silicon carbide substrate can be reduced.

## Description

### TECHNICAL FIELD

The present invention relates to a method for producing a polycrystalline silicon carbide substrate used for silicon carbide semiconductors etc. by bonding monocrystalline silicon carbides, and more particularly to a method for producing a polycrystalline silicon carbide substrate capable of reducing production costs without changing the quality of the polycrystalline silicon carbide substrate.

### BACKGROUND ART

Silicon carbide (SiC) is a wide-bandgap semiconductor having a wide forbidden band width of 2.2 to 3.3 eV, and due to its excellent physical and chemical properties, research and development as an environmentally resistant semiconductor material have been carried out. In recent years in particular, silicon carbide has attracted attention as a material for high-voltage and high-power electronic devices, high-frequency electronic devices, and short-wavelength optical devices ranging from blue to ultraviolet, and research and development have become active. However, it has been difficult to produce high-quality large-diameter monocrystalline silicon carbide, which has hindered the practical application of silicon carbide devices.

To solve this problem, an improved Rayleigh method has been developed in which sublimation recrystallization is performed using a monocrystalline silicon carbide substrate as a seed crystal. According to the improved Rayleigh method, it is possible to grow monocrystalline silicon carbide while controlling the crystal polymorphism of monocrystalline SiC (such as 4H-SiC, 6H-SiC, and 15R-SiC), shape, carrier type, and concentration. By optimizing the improved Rayleigh method, the crystal defect density is greatly reduced, and it has become possible to form electronic devices such as Schottky barrier diodes (SBDs) and metal oxide semiconductor field effect transistors (MOSFETs) on a silicon carbide substrate (a substrate provided for silicon carbide devices).

However, the improved Rayleigh method using a monocrystalline silicon carbide substrate as a seed crystal had a high production cost of the silicon carbide substrate due to the low crystal growth rate of monocrystalline silicon carbide and the high processing costs as a result of undergoing the steps primarily including cutting and polishing monocrystalline silicon carbide ingots into wafers. The high cost of production has also been a factor hindering the practical application of silicon carbide devices, and there has been a strong demand for the development of a technique capable of providing inexpensive silicon carbide substrates for semiconductor device applications, particularly for high-voltage and high-power device applications.

Under such a technical background, various measures have been taken to reduce the production cost of silicon carbide substrates. For example, Patent Document 1 discloses a method for producing a silicon carbide substrate formed by bonding a monocrystalline silicon carbide substrate and a polycrystalline silicon carbide substrate. That is, the document discloses a method for producing a silicon carbide substrate provided for silicon carbide devices, including bonding a monocrystalline silicon carbide substrate having a micropipe density of at least 30 counts/cm² or less and a polycrystalline silicon carbide substrate, and thinning the bonded monocrystalline silicon carbide substrate. It is to be noted that the active layer of the silicon carbide semiconductor device functions with the monocrystalline silicon carbide substrate, and the lower mechanical support portion and heat dissipation portion function with the polycrystalline silicon carbide substrate, making it possible to handle the entire silicon carbide substrate equivalently to a substrate composed of monocrystalline silicon carbide.

However, when a silicon carbide substrate is produced by bonding a monocrystalline silicon carbide substrate and a polycrystalline silicon carbide substrate by the method of Patent Document 1, there is a problem that the vertical electrical resistance of the substrate increases due to the influence of the oxide film formed at the bonding interface between the monocrystalline silicon carbide substrate and the polycrystalline silicon carbide substrate in applications for vertical power semiconductor devices; there are also problems such as the instability of the interface structure with respect to the heating treatment temperature (> 1200°C) in the silicon carbide device fabrication process.

Therefore, in the method for producing a silicon carbide substrate disclosed in Patent Document 2, the above problems are solved by adopting a bonding method at the bonding interface between the monocrystalline silicon carbide substrate and the polycrystalline silicon carbide substrate without forming an oxide film. That is, in the method for producing a silicon carbide substrate disclosed in Patent Document 2, damage is applied to the crystalline structure of the monocrystalline silicon carbide substrate to form a first amorphous layer, damage is also applied to the crystalline structure of the polycrystalline silicon carbide substrate to form a second amorphous layer, the first amorphous layer is brought into contact with the second amorphous layer, and heat treatment is performed while the first amorphous layer and the second amorphous layer are in contact with each other, thereby achieving a bonding method at the bonding interface between the monocrystalline silicon carbide substrate and the polycrystalline silicon carbide substrate without forming the above oxide film.

In high-voltage and high-power electronic devices, it is required to reduce the electrical resistance of the devices in order to suppress power loss. In the polycrystalline silicon carbide substrate that serves as the mechanical support portion etc. of the silicon carbide substrate produced by the method disclosed in Patent Document 2, crystal defects due to high-concentration nitrogen doping, which is a problem in monocrystalline silicon carbide, are not generated. Therefore, it is possible to configure a silicon carbide substrate composed of a low-electrical-resistance support substrate (i.e., a polycrystalline silicon carbide substrate).

Furthermore, polycrystalline silicon carbide is a material with aggregated fine grains of monocrystalline silicon carbide with a size of several tens of µm or less, so that polycrystalline silicon carbide has a high density of grain boundaries inside. Monocrystalline silicon carbide tends to be easily destroyed by so-called cleavage; that is, cracks originating from stress-concentrated places propagate along the crystal plane when stress is applied during device fabrication or operation. However, this crack propagation is inhibited at the grain boundaries inside the polycrystalline silicon carbide, so that polycrystalline silicon carbide has a higher fracture toughness than monocrystalline silicon carbide and is therefore difficult to fracture.

Therefore, the silicon carbide substrate produced by the method disclosed in Patent Document 2 has the advantage of being adaptable to further thinning, which is strongly desired for high-voltage and high-power device applications.

### PRIOR ART DOCUMENTS

### Patent Documents

Patent Document 1: Japanese Patent Application Publication No. 2009-117533
Patent Document 2: Japanese Patent No. 6061251
Patent Document 3: Japanese Patent Application Publication No. 2001-316821 (see paragraph 0014)

### DISCLOSURE OF THE INVENTION

### PROBLEM TO BE SOLVED BY THE INVENTION

Note that polycrystalline silicon carbide substrates used for the production of silicon carbide substrates have conventionally been produced by the following methods. For example, a silicon (Si)-based source and a carbon (C)-based source are supplied on an underlying substrate composed of carbon (C), polycrystalline silicon carbide is deposited thereon by a chemical vapor deposition (CVD) method, and then the polycrystalline silicon carbide is separated from the underlying substrate (see Patent Document 3); alternatively, a sintering aid or the like is used to press-mold fine crystal silicon carbide powder, and thereafter, the silicon carbide powder is adhered to each other at a temperature below the sublimation temperature of silicon carbide.

The polycrystalline silicon carbide substrate produced by the former method (Patent Document 3) is obtained as a dense substrate with extremely low concentration of metal impurities and no voids, while many voids remain in the polycrystalline silicon carbide substrate produced by the latter method. Therefore, those produced by the former method are desirable as polycrystalline silicon carbide substrates used for the production of the silicon carbide substrates.

However, the former method of producing a polycrystalline silicon carbide substrate by a chemical vapor deposition method still has the problem of high production costs.

First, in order to separate the deposited polycrystalline silicon carbide from the underlying substrate, a "combustion method" in which the underlying substrate is burnt in an oxygen-containing atmosphere (oxygen atmosphere) to separate the polycrystalline silicon carbide, or a "processing method" in which the underlying substrate is removed by grinding or polishing to separate the polycrystalline silicon carbide is employed. Since the underlying substrate is lost every time a polycrystalline silicon carbide substrate is produced by either method, the production cost of the polycrystalline silicon carbide substrate becomes expensive due to the waste of the underlying substrate.

Furthermore, when removing the underlying substrate by the "combustion method," it is necessary to expose the outer peripheral edge of the polycrystalline silicon carbide deposited on the surface of the underlying substrate by grinding or the like and to burn the exposed underlying substrate in an oxygen atmosphere for a long time. In the case of removing the underlying substrate by the "processing method," a long processing time is required as well, resulting in an increase in the production cost of the polycrystalline silicon carbide substrate.

The present invention has been made paying attention to such problems, and an object thereof to provide a method for producing a polycrystalline silicon carbide substrate capable of reducing production costs without changing the quality of the polycrystalline silicon carbide substrate.

### MEANS FOR SOLVING PROBLEM

Specifically, the first invention according to the present invention is a method for producing a polycrystalline silicon carbide substrate, including:
a carbon layer forming step of forming a carbon layer on a surface of a first underlying substrate to produce a second underlying substrate;
a polycrystalline silicon carbide film forming step of forming a polycrystalline silicon carbide film on a surface of the second underlying substrate by a chemical vapor deposition method;
a carbon layer exposing step of removing an outer peripheral edge of the polycrystalline silicon carbide film formed on the surface of the second underlying substrate to expose the carbon layer; and
a polycrystalline silicon carbide film separating step of burning the exposed carbon layer in an oxygen-containing atmosphere and separating the polycrystalline silicon carbide film from the second underlying substrate from which the carbon layer has been removed.

The second invention according to the present invention is the method for producing a polycrystalline silicon carbide substrate according to the first invention, further including a grinding step of grinding for flattening a surface of the separated polycrystalline silicon carbide film after the polycrystalline silicon carbide film separating step.

The third invention is the method for producing a polycrystalline silicon carbide substrate according to the first or second invention, wherein in the carbon layer forming step, an organic resist is applied to the surface of the first underlying substrate, and the formed organic resist film is heat-treated to form the carbon layer.

The fourth invention is the method for producing a polycrystalline silicon carbide substrate according to the first or second invention, wherein in the carbon layer forming step, the carbon layer is formed on the surface of the first underlying substrate by a sputtering method using a carbon target.

The fifth invention is the method for producing a polycrystalline silicon carbide substrate according to the first or second invention, wherein in the carbon layer forming step, a carbon sheet is adhered to the surface of the first underlying substrate to form the carbon layer.

Next, the sixth invention according to the present invention is the method for producing a polycrystalline silicon carbide substrate according to any one of the first to fifth inventions, wherein the first underlying substrate is made of monocrystalline silicon carbide, polycrystalline silicon carbide, sintered silicon carbide, or sapphire.

The seventh invention is the method for producing a polycrystalline silicon carbide substrate according to any one of the first to fifth inventions, wherein the first underlying substrate is composed of a complex of an isotropic carbon substrate and a silicon carbide film formed on a surface of the carbon substrate.

The eighth invention is the method for producing a polycrystalline silicon carbide substrate according to any one of the first to seventh inventions, wherein the first underlying substrate has a groove on the surface thereof, extending to an outer peripheral edge of the first underlying substrate.

### EFFECTS OF THE INVENTION

According to the method for producing a polycrystalline silicon carbide substrate of the present invention,
since the second underlying substrate on which the polycrystalline silicon carbide film is deposited is composed of the first underlying substrate and the carbon layer formed on the surface thereof,
it becomes possible to burn the carbon layer formed on the surface of the first underlying substrate and to separate the polycrystalline silicon carbide film from the second underlying substrate from which the carbon layer has been removed.

Therefore, it has the effect of reducing the production cost of the polycrystalline silicon carbide substrate because the first underlying substrate can be reused without being lost.

### BRIEF DESCRIPTION OF DRAWINGS

FIG. 1 is an explanatory diagram showing a production process of a polycrystalline silicon carbide substrate according to the present invention.
FIG. 2 is an explanatory diagram of a first underlying substrate composed of a complex of an isotropic carbon substrate and a silicon carbide film formed on a surface of the carbon substrate.
FIG. 3 is a graph showing the relationship between the "Number of Reuses (Times)" of the first underlying substrate (polycrystalline silicon carbide) used in Example 1 and the "Warp (µm)" of the produced polycrystalline silicon carbide substrate, and the relationship between the "Number of Reuses (Times)" of the first underlying substrate and the "Resistivity (Ωcm)" of the polycrystalline silicon carbide substrate.

### BEST MODES FOR PRACTICING THE INVENTION

Hereinafter, embodiments of the present invention will be described in detail with reference to the drawings, but the present invention is not naturally limited to the following embodiments, and various forms belonging to the technical scope of the present invention can be adopted.

First, the method for producing a polycrystalline silicon carbide substrate according to the present invention includes:
a carbon layer forming step of forming a carbon layer on a surface of a first underlying substrate to produce a second underlying substrate;
a polycrystalline silicon carbide film forming step of forming a polycrystalline silicon carbide film on a surface of the second underlying substrate by a chemical vapor deposition method;
a carbon layer exposing step of removing an outer peripheral edge of the polycrystalline silicon carbide film formed on the surface of the second underlying substrate to expose the carbon layer; and
a polycrystalline silicon carbide film separating step of burning the exposed carbon layer in an oxygen-containing atmosphere and separating the polycrystalline silicon carbide film from the second underlying substrate from which the carbon layer has been removed.

### (1) Carbon layer forming step

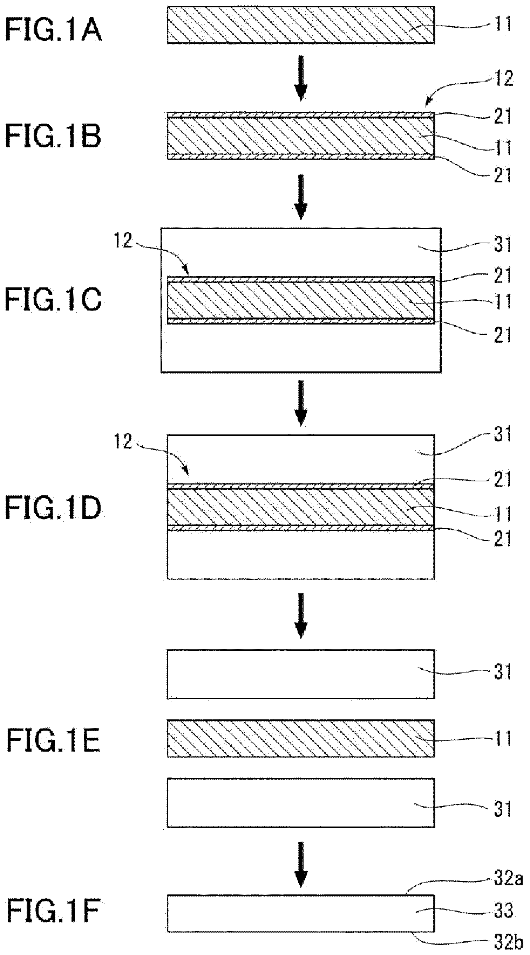

As shown in FIG. 1A to FIG. 1B, the carbon layer forming step is a step of forming a carbon layer 21 on the surface of a disc-shaped first underlying substrate 11 to produce a second underlying substrate 12.

The underlying substrate is a material serving as an underlying layer for forming (growing) a film. The first underlying substrate 11 is a material serving as an underlying layer for forming the carbon layer 21. The second underlying substrate 12 is composed of the first underlying substrate 11 and the carbon layer 21 formed on the surface thereof, and is a material serving as an underlying layer for growing a polycrystalline silicon carbide film.

### (1-1) First underlying substrate

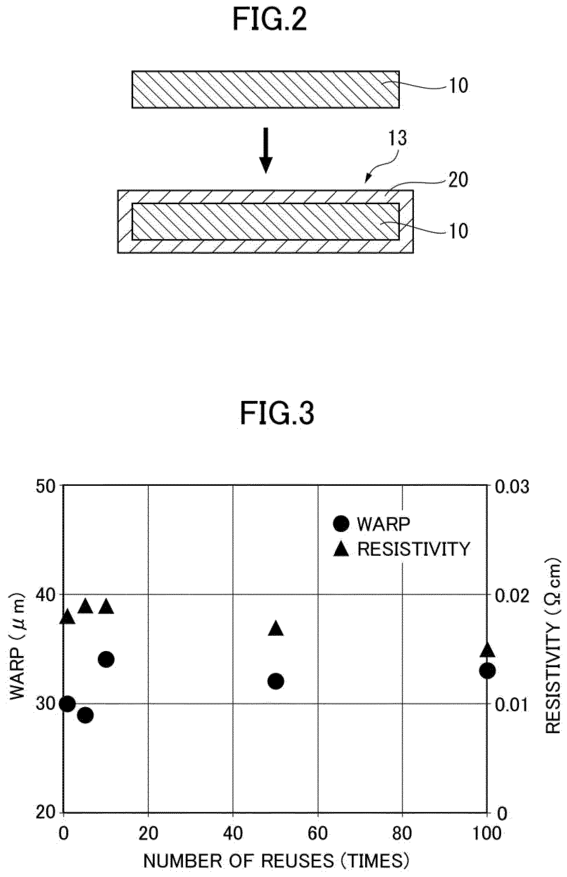

The first underlying substrate 11 is required to have heat resistance of 1200°C or higher, preferably 1300°C or higher, and a characteristic that it does not burn away even in an oxygen-containing atmosphere at 500°C or higher. For example, a substrate material composed of monocrystalline silicon carbide, polycrystalline silicon carbide, sintered silicon carbide, or sapphire can be mentioned. Furthermore, as shown in FIG. 2, a substrate composed of a complex 13 of an isotropic carbon substrate 10 and a silicon carbide film (such as a polycrystalline silicon carbide film) 20 formed on the surface of the carbon substrate 10 by a chemical vapor deposition (CVD) method can also be used. In this case, the thickness of the polycrystalline silicon carbide film is preferably 1 µm to 100 µm, more preferably 10 µm to 30 µm.

### (1-2) Carbon layer

To form the carbon layer 21 on the surface of the first underlying substrate 11, for example, an organic resist is applied with a spin coater, the formed organic resist film is heated at about 200°C to remove the solvent component from the organic resist film, and then carbonized at about 1000°C to form the carbon layer 21. The carbon layer 21 is formed in a thickness range of 0.1 µm to 10 um, and is preferably formed in a thickness range of 0.5 µm to 2 µm.

Instead of the method using an organic resist, the carbon layer may be formed by a sputtering method using a carbon target. For example, in a high vacuum processing chamber adjusted to a pressure of 1 × 10⁻¹ Pa or less, argon plasma may be directed onto a carbon target, and the carbon layer 21 may be deposited on the surface of the first underlying substrate 11 by a sputtering method. The carbon layer deposited by sputtering is deposited to a thickness of 0.1 µm to 5 µm, preferably 1 µm to 2 µm.

Furthermore, a carbon layer may be formed by adhering a carbon sheet to the surface of the first underlying substrate 11. That is, an adhesive may be applied to the surface of the first underlying substrate 11, and a carbon sheet may be adhered via the adhesive. A carbon-based adhesive may be used as the adhesive, and a flexible graphite sheet or a PGS Graphite Sheet (trade name, manufactured by Panasonic Holdings Corporation) may be used as the carbon sheet. A sheet having a thickness of 0.01 mm to 1.5 mm can be used as the carbon sheet, but a sheet having a thickness of 0.2 mm to 0.5 mm is preferable.

### (2) Polycrystalline silicon carbide film forming step

As shown in FIG. 1C, the polycrystalline silicon carbide film forming step is a step of forming a polycrystalline silicon carbide film 31 on the surface of the second underlying substrate 12 by a chemical vapor deposition (CVD) method. For example, the second underlying substrate is fixed in a reaction chamber of a film forming apparatus, the chamber is heated to a growth temperature (e.g. 1400°C) under reduced pressure with an inert carrier gas, such as argon, flowing, the inert gas is stopped when the growth temperature is reached, and source gas and carrier gas are introduced to form a polycrystalline silicon carbide film 31 on the surface of the second underlying substrate 12.

### (2-1) Source gas

As the source gas, any gas can be used as long as it can form a polycrystalline silicon carbide film without particular limitation, and Si-based source gases and C-based source gases commonly used can be used.

For example, as the silicon (Si)-based source gas, silane (SiH₄) can be used, and chlorine-containing Si source gases (chloride-based source gases) having an etching characteristic such as monochlorosilane (SiH₃Cl), dichlorosilane (SiH₂Cl₂), trichlorosilane (SiHCl₃), and tetrachlorosilane (SiCl₄) containing Cl can also be used.

As the carbon (C)-based source gas, for example, hydrocarbons such as methane (CH₄), ethane (C₂H₆), propane (C₃H₈), and acetylene (C₂H₂) can be used.

In addition to the above, gases containing both Si and C, such as tetramethylsilane [(CH₃)₄Si], trichloromethylsilane (CH₃Cl₃Si), trichlorophenylsilane (C₆H₅Cl₃Si), dichloromethylsilane (CH₄C1₂Si), dichlorodimethylsilane [(CH₃)₂SiCl₂], and chlorotrimethylsilane [(CH₃)₃SiCl], can also be used as source gases.

(2-2) As the carrier gas, any carrier gas commonly used can be used as long as it does not inhibit film formation and can deliver the source gas to the second underlying substrate. For example, hydrogen (H₂) having excellent thermal conductivity and etching characteristic on silicon carbide can be used.

(2-3) Also, when the polycrystalline silicon carbide substrate is applied to high-voltage and high-power devices, it is necessary to lower the resistivity of the polycrystalline silicon carbide film, and impurities (dopant gases) such as nitrogen or phosphorus are introduced into the polycrystalline silicon carbide film. The introduction concentration of nitrogen or phosphorus is, for example, 1 × 10¹⁹/cm³ or more.

### (3) Carbon layer exposing step

As shown in FIG. 1D, the carbon layer exposing step is a step of removing the outer peripheral edge of the polycrystalline silicon carbide film 31 formed on the surface of the second underlying substrate 12 to expose the outer peripheral edge of the carbon layer 21.

Due to the polycrystalline silicon carbide film forming step, the polycrystalline silicon carbide film 31 is also deposited on the outer peripheral portion of the second underlying substrate 12 as shown in FIG. 1C. Therefore, for example, this is placed in an edge grinding apparatus, and the outer peripheral edge of the carbon layer 21 can be exposed by grinding the edge face of the deposited polycrystalline silicon carbide film 31 inward by about 0.01 mm to 0.5 mm.

### (4) Polycrystalline silicon carbide film separating step

The polycrystalline silicon carbide film separating step is to burn the carbon layer 21 of FIG. 1D whose outer peripheral edge is exposed in an oxygen-containing atmosphere, and as shown in FIG. 1E, separate the polycrystalline silicon carbide film 31 from the first underlying substrate 11 (the first underlying substrate 11 from which the carbon layer 21 has been removed from the second underlying substrate).

That is, for example, by heating the second underlying substrate 12 having the exposed outer peripheral edge of the carbon layer 21 as shown in FIG. 1D and the polycrystalline silicon carbide film 31 formed on the surface under an oxygen-containing atmosphere (oxygen atmosphere) at 1000°C, the carbon layer 21 between the first underlying substrate 11 and the polycrystalline silicon carbide film 31 is burnt, so that two polycrystalline silicon carbide films 31 can be separated from the first underlying substrate 11.

Note that when the first underlying substrate 11 has a strip-shaped groove extending to the outer peripheral edge of the first underlying substrate 11 on the surface thereof, all or part of the opening end of the groove is also exposed in the carbon layer exposing step to act as an air introduction hole. It has the advantage of being able to efficiently burn the carbon layer interposed between the first underlying substrate 11 and the polycrystalline silicon carbide film 31. For example, when a carbon sheet is adhered to the surface of the first underlying substrate 11 having a groove, the opening end of the groove can be exposed in the carbon layer exposing step to serve as an air introduction hole.

As the dimensions of the groove, a depth of 0.01 mm to 1 mm and a width of 0.1 mm to 3 mm can be exemplified, and 1 to 10 lines vertically and 1 to 10 lines horizontally can be exemplified as the number of grooves.

### (5) Grinding step

The method for producing a polycrystalline silicon carbide substrate according to the present invention may have a grinding step of grinding for flattening the separated polycrystalline silicon carbide film surface after the polycrystalline silicon carbide film separating step.

That is, the growth top surface 32a and the growth back surface 32b of the polycrystalline silicon carbide film 31 shown in FIG. 1F separated from the first underlying substrate 11 are ground to obtain a polycrystalline silicon carbide substrate 33 having a thickness of about 0.35 mm, for example.

### Examples

Hereinafter, Examples of the present invention will be specifically described citing Comparative Examples.

### [Example 1]

A spin coater was used to apply an organic resist [Tokyo Ohka Kogyo Co., Ltd. epoxy resin based resist material: TMMR^{™} / F S2000] onto a disc-shaped first underlying substrate made of polycrystalline silicon carbide, the formed organic resist film was heated at 200°C to remove the solvent component, and then the organic resist film was carbonized at 1000°C to form a 0.5 µm thick carbon layer to produce a second underlying substrate.

Next, a chemical vapor deposition method was used to form a 1.35 mm thick polycrystalline silicon carbide film on both surfaces of the second underlying substrate. The film forming conditions were as follows: a reaction chamber internal pressure of 5 kPa, a growth temperature of 1350°C, dichlorosilane (SiH₂Cl₂) gas and acetylene (C₂H₂) gas flows of 1000 sccm and 500 sccm respectively, and a hydrogen carrier gas flow of 5000 sccm.

Next, the disc-shaped second underlying substrate having polycrystalline silicon carbide films formed on both surfaces was placed in an edge grinding apparatus, and the outer peripheral portion of the second underlying substrate was end-face ground by 0.05 mm to expose the outer peripheral edge of the carbon layer.

Then, the carbon layer with exposed outer peripheral edge was heated for 24 hours at 1000°C in an air atmosphere to burn it. After separating the polycrystalline silicon carbide from the first underlying substrate (the first underlying substrate from which the carbon layer had been removed from the second underlying substrate), the front surface and the back surface of the polycrystalline silicon carbide were both ground by 0.5 mm for flattening surface, thereby producing a polycrystalline silicon carbide substrate.

### [Comparative Example]

Using isotropic carbon as a disc-shaped underlying substrate, a 1.35 mm thick polycrystalline silicon carbide film was formed on both surfaces of the underlying substrate under the same conditions as in Example 1.

Then, the outer peripheral portion of the underlying substrate having polycrystalline silicon carbide films formed on both surfaces was edge-face ground by 0.05 mm to expose the outer peripheral edge of the isotropic carbon as the underlying substrate. The exposed outer peripheral edge of the isotropic carbon (underlying substrate) was burnt in an air atmosphere at 1000°C to separate the polycrystalline silicon carbide, and then the front surface and the back surface of the polycrystalline silicon carbide were both ground by 0.5 mm for flattening surface, thereby producing a polycrystalline silicon carbide substrate according to Comparative Example.

### [Confirmation]

When the "warp" and "resistivity" of the polycrystalline silicon carbide substrate according to Example 1 and the polycrystalline silicon carbide substrate according to Comparative Example were examined, no significant difference was found in the values of "Warp" and "Resistivity" as shown in Table 1.

However, in Comparative Example, it took a long time to burn the isotropic carbon (underlying substrate), and there was the disadvantage that the isotropic carbon (underlying substrate) was wastefully consumed every time the polycrystalline silicon carbide substrate was produced.

**[Table 1]**

| Warp | Example 1 30 µm | Compartive Example 32 µm |
|---|---|---|
| Resistivity | 0.018 Qcm | 0.015 Qcm |

### [Example 2]

On a disc-shaped first underlying substrate made of polycrystalline silicon carbide, a 0.3 mm thick flexible graphite sheet [Toyo Tanso Co., Ltd., trade name PERMA-FOIL] was adhered using a carbon adhesive [Nisshinbo Chemical Inc., trade name ST-201] to form a carbon layer, and a polycrystalline silicon carbide substrate according to Example 2 was produced in the same manner as in Example 1 except for the above.

When the "warp" and "resistivity" of the polycrystalline silicon carbide substrate according to Example 2 and the polycrystalline silicon carbide substrate according to Comparative Example above were examined, no significant difference was found in the values of "Warp" and "Resistivity" as shown in Table 2.

**[Table 2]**

| Warp | Example 2 35 µm | Compartive Example 32 µm |
|---|---|---|
| Resistivity | 0.014 Qcm | 0.015 Qcm |

### [Example 3]

Using the disc-shaped first underlying substrate (polycrystalline silicon carbide) used in Example 1 again, polycrystalline silicon carbide substrates were repeatedly produced under the same conditions as in Example 1, and the "warp" and "resistivity" of the produced polycrystalline silicon carbide substrates were examined, with the results shown in FIG. 3.

Note that FIG. 3 is a graph showing the relationship between the "Number of Reuses (Times)" of the first underlying substrate (polycrystalline silicon carbide) used in Example 1 and the "Warp (µm)" of the produced polycrystalline silicon carbide substrate, and the relationship between the "Number of Reuses (Times)" of the first underlying substrate and the "Resistivity (Ωcm)" of the polycrystalline silicon carbide substrate.

### [Confirmation]

### (1) "Warp (µm)" of polycrystalline silicon carbide substrate

As shown by the symbol "●" in FIG. 3, the use of the first underlying substrate (polycrystalline silicon carbide) according to the first time resulted in "warp = 30 µm" (see Example 1), the use of the first underlying substrate according to the fifth time resulted in "warp approximately 29 um," the use of the first underlying substrate according to the tenth time resulted in "warp approximately 34 um," the use of the first underlying substrate according to the fiftieth time resulted in "warp approximately 32 um," and the use of the first underlying substrate according to the hundredth time resulted in "warp approximately 33 µm."

From this, it was confirmed that the "warp (µm)" of the polycrystalline silicon carbide substrate was substantially constant independently of the number of reuses of the first underlying substrate, and no significant difference was found from the "warp = 32 µm" according to Comparative Example.

### (2) "Resistivity (Qcm)" of polycrystalline silicon carbide substrate

As shown by the symbol "A" in FIG. 3, the use of the first underlying substrate (polycrystalline silicon carbide) according to the first time resulted in a "resistivity = 0.018 Ωcm" (see Example 1), the use of the first underlying substrate according to the fifth time resulted in a "resistivity of approximately 0.019 Ωcm," the use of the first underlying substrate according to the tenth time resulted in a "resistivity of approximately 0.019 Ωcm," the use of the first underlying substrate according to the fiftieth time resulted in a "resistivity of approximately 0.017 Ωcm," and the use of the first underlying substrate according to the hundredth time resulted in a "resistivity of approximately 0.015 Ωcm."

From this, it was confirmed that the "resistivity (Qcm)" of the polycrystalline silicon carbide substrate was also substantially constant independently of the number of reuses of the first underlying substrate, and no significant difference was found from the "resistivity = 0.015 Qcm" according to Comparative Example.

### POSSIBILITY OF INDUSTRIAL APPLICATION

According to the method for producing a polycrystalline silicon carbide substrate according to the present invention, since production costs can be reduced without changing the quality of the polycrystalline silicon carbide substrate, it has industrial applicability as a production method for a polycrystalline silicon carbide substrate used for silicon carbide semiconductors etc. in which monocrystalline silicon carbides are bonded.

### EXPLANATIONS OF LETTERS AND NUMERALS

- 10: isotropic carbon substrate
- 11: first underlying substrate
- 12: second underlying substrate
- 13: complex
- 20: silicon carbide film
- 21: carbon layer
- 31: polycrystalline silicon carbide film
- 32a: growth top surface
- 32b: growth back surface
- 33: polycrystalline silicon carbide substrate

## Claims

1. A method for producing a polycrystalline silicon carbide substrate, comprising:
a carbon layer forming step of forming a carbon layer on a surface of a first underlying substrate to produce a second underlying substrate;
a polycrystalline silicon carbide film forming step of forming a polycrystalline silicon carbide film on a surface of the second underlying substrate by a chemical vapor deposition method;
a carbon layer exposing step of removing an outer peripheral edge of the polycrystalline silicon carbide film formed on the surface of the second underlying substrate to expose the carbon layer; and
a polycrystalline silicon carbide film separating step of burning the exposed carbon layer in an oxygen-containing atmosphere and separating the polycrystalline silicon carbide film from the second underlying substrate from which the carbon layer has been removed.

2. The method for producing a polycrystalline silicon carbide substrate according to claim 1,
further comprising a grinding step of grinding for flattening a surface of the separated polycrystalline silicon carbide film after the polycrystalline silicon carbide film separating step.

3. The method for producing a polycrystalline silicon carbide substrate according to claim 1 or 2, wherein in the carbon layer forming step, an organic resist is applied to the surface of the first underlying substrate, and the formed organic resist film is heat-treated to form the carbon layer.

4. The method for producing a polycrystalline silicon carbide substrate according to claim 1 or 2, wherein in the carbon layer forming step, the carbon layer is formed on the surface of the first underlying substrate by a sputtering method using a carbon target.

5. The method for producing a polycrystalline silicon carbide substrate according to claim 1 or 2, wherein in the carbon layer forming step, a carbon sheet is adhered to the surface of the first underlying substrate to form the carbon layer.

6. The method for producing a polycrystalline silicon carbide substrate according to any one of claims 1 to 5, wherein the first underlying substrate is made of monocrystalline silicon carbide, polycrystalline silicon carbide, sintered silicon carbide, or sapphire.

7. The method for producing a polycrystalline silicon carbide substrate according to any one of claims 1 to 5, wherein the first underlying substrate is composed of a complex of an isotropic carbon substrate and a silicon carbide film formed on a surface of the carbon substrate.

8. The method for producing a polycrystalline silicon carbide substrate according to any one of claims 1 to 7, wherein the first underlying substrate has a groove on the surface thereof, extending to an outer peripheral edge of the first underlying substrate.
